# EUROPEAN PATENT APPLICATION

(11) **EP 4 783 768 A1**
(43) Date of publication of application: **29.07.2026**
(21) Application number: 25154302.1
(22) Date of filing: 28.01.2025
(51) Int. Cl.: H10D 30/01, H10D 30/66, H10D 62/10, H10D 64/00, H10D 64/23

(54) **SEMICONDUCTOR DEVICE AND A METHOD OF MANUFACTURING THEREOF**

(71) Applicant: Huawei Technologies Co., Ltd., Shenzhen, Guangdong 518129 (CN)
(72) Inventor: CHANG, Mo Huai, 80992 Munich (DE); ZHANG, Feixiang, 80992 Munich (DE); HE, Junqing, 80992 Munich (DE); HE, Linrong, 80992 Munich (DE)
(74) Representative: Körber, Martin Hans

(57) **Abstract**

In some examples, a method of manufacturing a semiconductor device comprises forming a first source field plate structure, the first source field plate structure comprising a first source field plate and a first field dielectric surrounding the first source field plate, forming a second source field plate surrounding the first source field plate structure, wherein the second source field plate is separated from the first source field plate by a second field dielectric, wherein a length of the first source field plate is greater than a length of the second source field plate, forming a third field dielectric separating the second source field plate from implant zones, forming a gate structure comprising: a gate electrode surrounding the first source field plate structure, and a gate dielectric separating the gate electrode from the implant zones, and forming a contact structure to provide an electrical connection to the first source field plate structure.

## Description

### TECHNICAL FIELD

The present disclosure relates, in general, to improvements in the design and performance of trench power metal-oxide-semiconductor field-effect transistors (MOSFETs). Aspects of the disclosure relate to methods and structures for achieving enhanced device characteristics.

### BACKGROUND

Silicon trench power MOSFETs have long been the cornerstone of various industrial applications due to their superior efficiency and performance compared to planar designs. Over the past three decades, these devices have undergone continuous evolution to address the growing demand for higher efficiency, faster switching, and better thermal performance. The transition from lateral channel, planar gate devices to advanced trench technologies has yielded significant advancements in key performance metrics such as ON-resistance (R_{DSON}), total gate charge (Qg), and switching losses.

The state-of-the-art needle trench technology represents the latest step in this evolution, offering innovative designs that combine lateral charge compensation with a grid-like layout to optimise current conduction and reduce power losses. This approach has significantly enhanced device characteristics, including ON-resistance, gate-to-drain charge (Q_{GD}), and reverse recovery charge (Q_{RR}), making it a preferred choice for modern high-speed switching applications.

Despite these advancements, further improvements in device performance are constrained by the challenges associated with increasing cell density. While a higher cell density can reduce ON-resistance, it also increases gate-to-drain charge and total gate charge, leading to issues such as spurious turn-on events in high-frequency applications. These undesired events can compromise circuit performance, stability, and reliability, particularly in configurations like half-bridge topologies where simultaneous conduction of high-side and low-side transistors must be avoided.

Efforts to reduce cell pitch to enhance performance introduce additional complications. Shrinking cell dimensions often necessitates the use of advanced lithography equipment and modified contact structures, which increase manufacturing complexity and costs. Moreover, tighter design constraints impose challenges in maintaining reliability, as smaller contact areas may require new barrier metal stacks or re-engineered contact modules, further complicating the production process.

### SUMMARY

An objective of the present disclosure is to provide a novel needle trench device concept that uses multi-field plate (or multi-electrode) in the field electrode structure to enable further re-shaping the electrical field distribution throughout the device structure.

The foregoing and other objectives are achieved by the features of the independent claims.

Further implementation forms are apparent from the dependent claims, the description and the Figures.

A first aspect of the present disclosure provides a method of manufacturing a semiconductor device, the method comprising forming a first source field plate structure, the first source field plate structure comprising a first source field plate and a first field dielectric surrounding the first source field plate, forming a second source field plate surrounding the first source field plate structure, wherein the second source field plate is separated from the first source field plate by a second field dielectric, wherein a length of the first source field plate is greater than a length of the second source field plate, forming a third field dielectric separating the second source field plate from implant zones, forming a gate structure comprising: a gate electrode surrounding the first source field plate structure, and a gate dielectric separating the gate electrode from the implant zones, and forming a contact structure to provide an electrical connection to the first source field plate structure.

Accordingly, a multi-field plate structure can be provided, offering a reduction in ON-resistance, a reduction in gate charge, and a reduction in gate-to-drain charge. By offering the design freedom with regard to the exact geometry of the second source field plate, a desired device characteristic may be optimised. Additionally, the invention is based on the existing needle trench concept and offers all of the advantages associated therewith. Importantly, the device can be manufactured using the existing process line with minimal process adaptation.

Forming the second source field plate may comprise recessing an upper portion of the first field dielectric and filling the recessed upper portion with a second source field plate material.

The method may further comprise forming the implant zones, wherein the implant zones comprise an N+ source implant zone, and a P-body implant zone, the P-body implant zone forming a channel.

Forming the contact structure may comprise forming the contact structure by adopting a bridge contact scheme, wherein the second source field plate and the first source field plate may be connected via a bridge, and wherein a single contact may be placed over the bridge.

Forming the contact structure may comprise forming the contact structure by adopting a direct contact scheme, wherein the first source field plate and the second source field plate may be individually connected with a contact placed over each one of the first source field plate and the second source field plate.

Forming the contact structure may comprise forming the contact structure by adopting a full contact scheme, wherein the top of the first source field plate structure may be recessed, and a single large contact may connect the first source field plate, the second source field plate, and the implant zones.

Forming the first source field plate structure may comprise forming, in an epitaxial layer, an isolation trench. Depositing a conductive material into the isolation trench may form the first source field plate. The first source field plate may then be planarised, whereby a surface of the epitaxial layer and the first source field plate may be aligned.

Forming the second source field plate may comprise partially recessing the first field dielectric layer. Depositing a conductive material into a recessed portion of the first field dielectric layer may form the second source field plate.

The method may further comprise forming a layer of bottom field dielectric. A thickness of the bottom field dielectric may be greater than a thickness of the first field dielectric.

A second aspect of the present disclosure provides a semiconductor device comprising a first source field plate structure comprising a first source field plate and a first field dielectric surrounding the first source field plate, a second source field plate surrounding the first source field plate, separated from the first source field plate via a second field dielectric, wherein a length of the first source field plate is greater than a length of the second source field plate, a third field dielectric arranged to separate the second source field plate from implant zones, a gate structure comprising a gate electrode surrounding the first source field plate structure, and a gate dielectric separating the gate electrode from the implant zones, and a contact structure arranged to provide an electrical connection to the first source field plate structure.

The implant zones may comprise an N+ source implant zone and a P-body implant zone arranged to form a channel.

The contact structure may comprise a bridge contact structure comprising a bridge arranged to connect the first source field plate and the second source field plate. A single contact may be arranged at a top portion of the bridge.

The contact structure may comprise a direct contact structure comprising multiple contacts. The multiple contacts may be arranged to provide a separate electrical connection to the first source field plate and the second source field plate, respectively.

The contact structure may comprise a full contact structure comprising a single large contact arranged to connect the first source field plate, the second source field plate, and the implant zones.

The semiconductor device may further comprise a layer of bottom field dielectric, wherein a thickness of the bottom field dielectric may be greater than a thickness of the first field dielectric.

These and other aspects of the invention will be apparent from the embodiment(s) described below.

### BRIEF DESCRIPTION OF THE DRAWINGS

In order that the present invention may be more readily understood, embodiments of the invention will now be described, by way of example, with reference to the accompanying drawings, in which:
Figure 1 is a flow chart of a method of manufacturing a semiconductor device according to an example;
Figure 2 is a schematic representation of a semiconductor device according to an example,
Figure 3a is a schematic representation of a semiconductor device comprising a first contact, according to an example;
Figure 3b is a schematic representation of a semiconductor device comprising a second contact, according to an example; and
Figure 3c is a schematic representation of a semiconductor device comprising a third contact, according to an example.

### DETAILED DESCRIPTION

Example embodiments are described below in sufficient detail to enable those of ordinary skill in the art to embody and implement the systems and processes herein described. It is important to understand that embodiments can be provided in many alternate forms and should not be construed as limited to the examples set forth herein.

Accordingly, while embodiments can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

The terminology used herein to describe embodiments is not intended to limit the scope. The articles "a," "an," and "the" are singular in that they have a single referent, however the use of the singular form in the present document should not preclude the presence of more than one referent. In other words, elements referred to in the singular can number one or more, unless the context clearly indicates otherwise. It will be further understood that the terms "comprises," "comprising," "includes," and/or "including," when used herein, specify the presence of stated features, items, steps, operations, elements, and/or components, but do not preclude the presence or addition of one or more other features, items, steps, operations, elements, components, and/or groups thereof.

Unless otherwise defined, all terms (including technical and scientific terms) used herein are to be interpreted as is customary in the art. It will be further understood that terms in common usage should also be interpreted as is customary in the relevant art and not in an idealized or overly formal sense unless expressly so defined herein.

The present disclosure is described with reference to flow charts and/or block diagrams of the method, devices and systems according to examples of the present disclosure. Although the flow diagrams described above show a specific order of execution, the order of execution may differ from that which is depicted. Blocks described in relation to one flow chart may be combined with those of another flow chart. In some examples, some blocks of the flow diagrams may not be necessary and/or additional blocks may be added. It shall be understood that each flow and/or block in the flow charts and/or block diagrams, as well as combinations of the flows and/or diagrams in the flow charts and/or block diagrams can be realized by machine readable instructions.

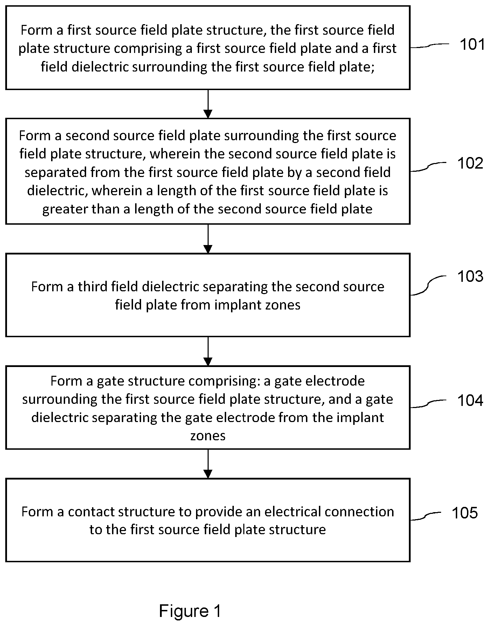

Figure 1 is a flow chart of a method of manufacturing a semiconductor device according to an example. The method comprises, in block 101, forming a first source field plate structure, the first source field plate structure comprising a first source field plate and a first field dielectric surrounding the first source field plate. The source field plate may comprise a conductive electrode used to control the electrical field distribution in the semiconductor device. The source field plate may comprise a conductive material. The conductive material may comprise, for example, a polysilicon or a metal such as aluminium or tungsten. In contrast, the first field dielectric may comprise an insulating material such as silicon dioxide or silicon nitride, which electrically insulate the first source field plate from the surrounding structures.

Forming the first source field plate structure may comprise forming, in an epitaxial layer, an isolation trench. An epitaxial layer is a semiconductor layer grown on a substrate. This layer may comprise silicon, silicon carbide, or other semiconducting materials, and functions as the active region of the device where current flows.

The isolation trench refers to a trench etched into the epitaxial layer to electrically separate regions of the device, making it possible to form the different field plate structures. A conductive material may be deposited into the isolation trench, whereby to form the first source field plate. The conductive material may comprise doped polysilicon or a metal, e.g., tungsten or aluminium. The first source field plate may then be planarised, whereby to align a surface of the epitaxial layer and the first source field plate, creating a smooth surface for subsequent layers to be formed.

In block 102, the method comprises forming a second source field plate surrounding the first source field plate structure, wherein the second source field plate is separated from the first source field plate by a second field dielectric, wherein a length of the first source field plate is greater than a length of the second source field plate. The second source field plate and the first source field plate may comprise the same material or different conductive materials. Similarly, the second field dielectric may comprise the same insulating material as the first field dielectric, or a different insulating material.

Forming the second source field plate may comprise recessing an upper portion of the first field dielectric and filling the recessed upper portion with a second source field plate material. Forming the second source field plate may comprise partially recessing the first field dielectric layer and depositing a conductive material into a recessed portion of the first field dielectric layer, whereby to form the second source field plate.

The method comprises, in block 103, forming a third field dielectric separating the second source field plate from implant zones. The third field dielectric, such as a thicker layer of silicon dioxide, acts as an insulator to prevent unwanted electrical interaction between the second source field plate and the implant zones. The third field dielectric may comprise the same material as the first field dielectric and/or the second field dielectric.

The method may further comprise forming the implant zones. The implant zones are regions within the epitaxial layer where dopants are introduced to create the desired electrical properties. The implant zones may comprise an N+ source implant zone and a P-body implant zone, wherein the P-body implant zone may form a channel. The N+ source implant zone is heavily doped with donor atoms to form the source, while the P-body implant zone is doped with acceptor atoms to form a channel when a voltage is applied to the gate.

In block 104, the method comprises forming a gate structure comprising: a gate electrode surrounding the first source field plate structure, and a gate dielectric separating the gate electrode from the implant zones. The gate electrode controls the flow of current in the channel, while the gate dielectric provides effective insulation to minimise gate leakage. The gate dielectric may comprise a high-k material.

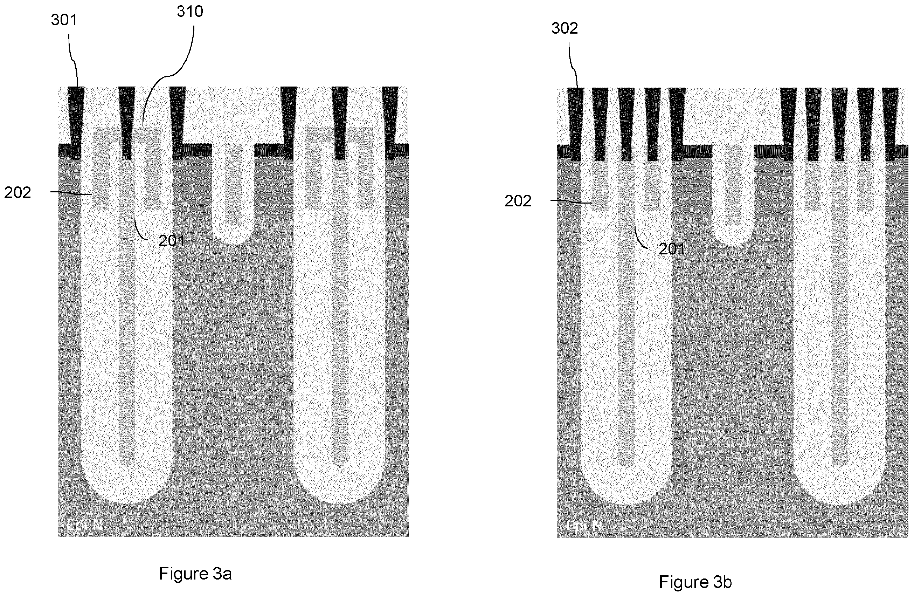

In block 105, the method comprises forming a contact structure to provide an electrical connection to the first source field plate structure. The contact structure will be described in more detail in relation to Figures 3a-3c.

The method may further comprise forming a layer of bottom field dielectric, wherein a thickness of the bottom field dielectric is greater than a thickness of the first field dielectric. The bottom field dielectric may be thicker than other dielectric layers. The bottom field dielectric may serve to provide additional insulation at the base of the field plate structure.

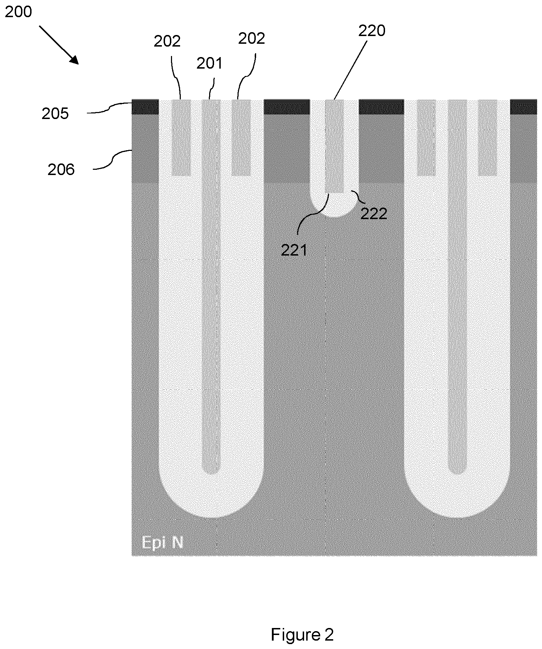

Figure 2 is a schematic representation of a semiconductor device according to an example. In particular, it is a cross-section view of the semiconductor device. The semiconductor device 200 may be a device manufactured using the above-described method of manufacturing.

The semiconductor device 200 comprises a first source field plate structure comprising a first source field plate 201 and a first field dielectric surrounding the first source field plate 201. The semiconductor device 200 also comprises a second source field plate 202, separated from the first source field plate 201 via a second field dielectric. The first source field plate 201 is longer than the second source field plate 202.

The semiconductor device 200 further comprises a third field dielectric arranged to separate the second source field plate 202 from implant zones, and a gate structure 220. The implant zones may comprise an N+ source implant zone 205, and a P-body implant zone 206 arranged to form a channel. The gate structure 220 comprises a gate electrode 221 surrounding the first source field plate structure 201, and a gate dielectric 222 separating the gate electrode from the implant zones.

The semiconductor device further comprises a contact structure arranged to provide an electrical connection to the first source field structure 201. The contact structure, not shown in Figure 2, will now be discussed in relation to Figures 3a-3c.

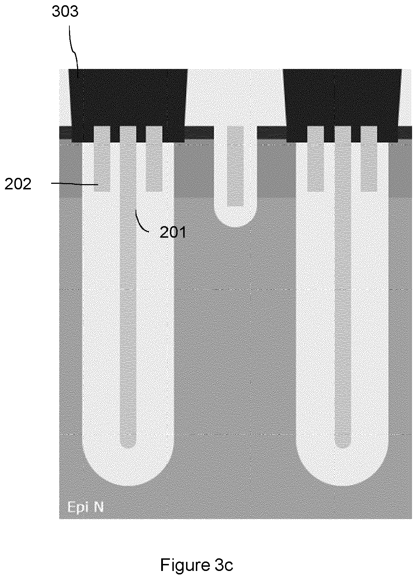

Figure 3a is a schematic representation of a semiconductor device comprising a first contact, according to an example. The same reference numerals in Figures 2 and 3a, 3b and 3c refer to the same elements and function likewise. The first contact may comprise a bridge contact, wherein the second source field plate 202 and the first source field plate 201 are connected via a bridge structure 310. In Figure 3a, the contacts are denoted using the reference numeral 301. A single contact 301 may be placed over the bridge 310, thus connecting all the field plates within the field plate structure to a source terminal. Two more contacts may be placed next to the field plate structure, connecting the source 205 and p-body 206 zones.

To build the semiconductor device of Figure 3a, having the bridge contact, the same process as the one described in relation to Figure 1 may be utilised. Firstly, an epitaxial layer may be formed on the substrate, followed by the formation of an active trench and a gate dielectric. A thick bottom oxide layer may then be formed, to provide additional insulation at the base. A conductive material may be deposited into the active trench, thus forming the gate electrode. The structure may then be planarised, ensuring a smooth surface for subsequent steps. A deep trench may then be formed, followed by the deposition of a thick dielectric layer and the deposition of conductive material into the trench, whereby to form the first source field plate. The structure may be planarised again. The thick dielectric layer may then be recessed and a conductive material may be deposited into the recess, forming the second source field plate. The conductive material may be etched to form a bridge structure. The implant zones may then be formed through P-type implantation (forming the p-body) and N-type implantation (forming the source). Following this, a dielectric layer may be deposited, forming the inter layer dielectric. Finally, a contact may be formed and metal may be deposited.

Figure 3b is a schematic representation of a semiconductor device comprising a second contact, according to an example. The second contact may comprise a direct contact, wherein the first source field plate 201 and the second source field plate 202 are individually connected with a contact placed over each one of the first source field plate 201 and the second source field plate 202.

In other words, in this scheme, the second source field plate 202 and the first source field plate 201 may be connected individually. Contacts 302 may be placed over the source field plates within the field plate structure, thus connecting all the source field plates to a source terminal. Contact to the second source field plate 202 may be continuous, i.e., forming a ring, or discontinuous, i.e., using lines or dots. Two more contacts 302 may be placed next to the field plate structure, connecting the source and p-body zones. The exact method of manufacturing the device of Figure 3b is the same as the method of manufacturing the device of Figure 3c and will be described below in relation to Figure 3c.

Figure 3c is a schematic representation of a semiconductor device comprising a third contact, according to an example. The third contact may comprise a full contact, wherein a top of the first source field plate structure is recessed, and a single large contact connects the first source field plate 201, the second source field plate 202 and the implant zones 205, 206.

In other words, in this scheme, the second source field plate 202 and the first source field plate 201 are connected together via a single large contact. The entire upper portion of the device may be recessed (including the second field dielectric, third field dielectric and silicon), so that a large contact 303 may be placed over the upper portion of the field plate structure. Importantly, the large contact structure 303 may be slightly wider than the width of the field plate structure. The single large contact 303 may connect all of the source field plates within the device, as well as the implant zones, to the source terminal.

To build the semiconductor device of Figures 3b and 3c, having the direct contact or the full contact, the same process as the one described in relation to Figure 1 may be utilised. Firstly, an epitaxial layer may be formed on the substrate, followed by the formation of an active trench and a gate dielectric. A thick bottom oxide layer may then be formed, to provide additional insulation at the base. A conductive material may be deposited into the active trench, thus forming the gate electrode. The structure may then be planarised, ensuring a smooth surface for subsequent steps. A deep trench may then be formed, followed by the deposition of a thick dielectric layer and the deposition of conductive material into the trench, whereby to form the first source field plate. The structure may be planarised again. The thick dielectric layer may then be recessed and a conductive material may be deposited into the recess, forming the second source field plate. This may be followed by another planarisation, followed by formation of the implant zones achieved by P-type implantation (forming the p-body) and N-type implantation (forming the source). Following this, a dielectric layer may be deposited, forming the inter layer dielectric. Finally, a contact may be formed and metal may be deposited.

The preceding description has been provided to enable others skilled in the art to best utilize various aspects of the exemplary embodiments disclosed herein. This exemplary description is not intended to be exhaustive or to be limited to any precise form disclosed. Many modifications and variations are possible without departing from the spirit and scope of the instant disclosure. The embodiments disclosed herein should be considered in all respects illustrative and not restrictive. Reference should be made to the appended claims and their equivalents in determining the scope of the instant disclosure.

## Claims

1. A method of manufacturing a semiconductor device, the method comprising:
forming a first source field plate structure, the first source field plate structure comprising a first source field plate and a first field dielectric surrounding the first source field plate (101);
forming a second source field plate surrounding the first source field plate structure, wherein the second source field plate is separated from the first source field plate by a second field dielectric, wherein a length of the first source field plate is greater than a length of the second source field plate (102);
forming a third field dielectric separating the second source field plate from implant zones (103);
forming a gate structure comprising: a gate electrode surrounding the first source field plate structure, and a gate dielectric separating the gate electrode from the implant zones (104); and
forming a contact structure to provide an electrical connection to the first source field plate structure (105).

2. The method of claim 1, wherein forming the second source field plate (102) comprises recessing an upper portion of the first field dielectric and filling the recessed upper portion with a second source field plate material.

3. The method of claim 1 or 2, further comprising:
forming the implant zones, wherein the implant zones comprise an N+ source implant zone, and a P-body implant zone, the P-body implant zone forming a channel.

4. The method of claim 1, 2 or 3, wherein forming the contact structure (105) comprises:
forming the contact structure by adopting a bridge contact scheme, wherein the second source field plate and the first source field plate are connected via a bridge, wherein a single contact is placed over the bridge.

5. The method of claim 1, 2 or 3, wherein forming the contact structure (105) comprises:
forming the contact structure by adopting a direct contact scheme, wherein the first source field plate and the second source field plate are individually connected with a contact placed over each one of the first source field plate and the second source field plate.

6. The method of claim 1, 2 or 3, wherein forming the contact structure (105) comprises:
forming the contact structure by adopting a full contact scheme, wherein a top of the first source field plate structure is recessed, and a single large contact connects the first source field plate, the second source field plate and the implant zones.

7. The method of any one of claims 1 to 6, wherein forming the first source field plate structure (101) comprises:
forming, in an epitaxial layer, an isolation trench;
depositing a conductive material into the isolation trench, whereby to form the first source field plate;
planarising the first source field plate, whereby to align a surface of the epitaxial layer and the first source field plate.

8. The method of any one of claims 1 to 7, wherein forming the second source field plate (102) comprises:
partially recessing the first field dielectric layer and depositing a conductive material into a recessed portion of the first field dielectric layer, whereby to form the second source field plate.

9. The method of any one of claims 1 to 8, further comprising:
forming a layer of bottom field dielectric, wherein a thickness of the bottom field dielectric is greater than a thickness of the first field dielectric.

10. A semiconductor device (200) comprising:
a first source field plate structure comprising a first source field plate (201) and a first field dielectric surrounding the first source field plate (201);
a second source field plate (202) surrounding the first source field plate structure, separated from the first source field plate (201) via a second field dielectric, wherein a length of the first source field plate (201) is greater than a length of the second source field plate (202);
a third field dielectric arranged to separate the second source field plate (202) from implant zones;
a gate structure (220) comprising a gate electrode (221) surrounding the first source field plate structure, and a gate dielectric (222) separating the gate electrode (221) from the implant zones; and
a contact structure arranged to provide an electrical connection to the first source field plate structure.

11. The semiconductor device of claim 10, wherein the implant zones comprise an N+ source implant zone (205), and a P-body implant zone (206) arranged to form a channel.

12. The semiconductor device of claim 10 or 11, wherein the contact structure comprises:
a bridge contact structure comprising a bridge (310) arranged to connect the first source field plate (201) and the second source field plate (202), and a single contact (301) arranged at a top portion of the bridge.

13. The semiconductor device of claim 10 or 11, wherein the contact structure comprises:
a direct contact structure comprising multiple contacts (302), wherein the multiple contacts (302) are arranged to provide a separate electrical connection to the first source field plate (201) and a second source field plate (202) respectively.

14. The semiconductor device of claim 10 or 11, wherein the contact structure comprises:
a full contact structure comprising a single large contact (303) arranged to connect the first source field plate (201), the second source field plate (202), and the implant zones.

15. The semiconductor device of any one of claims 10 to 14, further comprising a layer of bottom field dielectric, wherein a thickness of the bottom field dielectric is greater than a thickness of the first field dielectric.

## Amended claims

### Amended claims in accordance with Rule 137(2) EPC.

1. A method of manufacturing a semiconductor device, the method comprising:
forming (101) a first source field plate structure, the first source field plate structure comprising a first source field plate and a first field dielectric surrounding the first source field plate;
forming (102) a second source field plate surrounding the first source field plate structure, wherein the second source field plate is separated from the first source field plate by a second field dielectric, wherein a length of the first source field plate is greater than a length of the second source field plate, and wherein the second field dielectric comprises a same insulating material as the first field dielectric, or a different insulating material;
forming (103) a third field dielectric separating the second source field plate from implant zones(;
forming (104) a gate structure comprising: a gate electrode surrounding the first source field plate structure, and a gate dielectric separating the gate electrode from the implant zones ;
forming (105) a contact structure to provide an electrical connection to the first source field plate structure ; and
forming a metal electrode on the contact structure;
wherein forming (101) the first source field plate structure comprises:
forming, in an epitaxial layer, an isolation trench, wherein the isolation trench is a deep trench, and wherein the gate electrode is formed in other trench, the other trench surrounding the deep trench;
depositing a conductive material into the isolation trench, whereby to form the first source field plate,;
planarising the first source field plate, whereby to align a surface of the epitaxial layer and the first source field plate;
wherein the method further comprises:
forming the implant zones, wherein the implant zones comprise an N+ source implant zone, and a P-body implant zone, the P-body implant zone forming a channel.

2. The method of claim 1, wherein forming (102) the second source field plate comprises recessing an upper portion of the first field dielectric and filling the recessed upper portion with a second source field plate material.

3. The method of claim 1 or 2, wherein forming (105) the contact structure comprises:
forming the contact structure by adopting a bridge contact scheme, wherein the second source field plate and the first source field plate are connected via a bridge, wherein a single contact is placed over the bridge.

4. The method of claim 1 or 2, wherein forming (105) the contact structure comprises:
forming the contact structure by adopting a direct contact scheme, wherein the first source field plate and the second source field plate are individually connected with a contact placed over each one of the first source field plate and the second source field plate.

5. The method of claim 1 or 2, wherein forming (105) the contact structure comprises:
forming the contact structure by adopting a full contact scheme, wherein a top of the first source field plate structure is recessed, and a single large contact connects the first source field plate, the second source field plate and the implant zones.

6. The method of any one of claims 1 to 5, wherein forming (102) the second source field plate comprises:
partially recessing the first field dielectric layer and depositing a conductive material into a recessed portion of the first field dielectric layer, whereby to form the second source field plate.

7. The method of any one of claims 1 to 6, further comprising:
forming a layer of bottom field dielectric on a bottom side of the deep trench, wherein a thickness of the bottom field dielectric is greater than a thickness of the first field dielectric.

8. A semiconductor device (200) comprising:
a first source field plate structure comprising a first source field plate (201) and a first field dielectric surrounding the first source field plate (201);
a second source field plate (202) surrounding the first source field plate structure, separated from the first source field plate (201) via a second field dielectric, wherein a length of the first source field plate (201) is greater than a length of the second source field plate (202), and wherein the second field dielectric comprises a same insulating material as the first field dielectric, or a different insulating material;
a third field dielectric arranged to separate the second source field plate (202) from implant zones;
a gate structure (220) comprising a gate electrode (221) surrounding the first source field plate structure, and a gate dielectric (222) separating the gate electrode (221) from the implant zones;
a contact structure arranged to provide an electrical connection to the first source field plate structure;and
a metal electrode arranged on the contact structure;
wherein the first source field plate structure is formed in an isolation trench, wherein the isolation trench is a deep trench, and wherein the gate electrode is formed in other trench, the other trench surrounding the deep trench;wherein the implant zones comprise an N+ source implant zone (205), and a P-body implant zone (206) arranged to form a channel.

9. The semiconductor device of claim 8, wherein the contact structure comprises:
a bridge contact structure comprising a bridge (310) arranged to connect the first source field plate (201) and the second source field plate (202), and a single contact (301) arranged at a top portion of the bridge.

10. The semiconductor device of claim 8, wherein the contact structure comprises:
a direct contact structure comprising multiple contacts (302), wherein the multiple contacts (302) are arranged to provide a separate electrical connection to the first source field plate (201) and a second source field plate (202) respectively.

11. The semiconductor device of claim 8, wherein the contact structure comprises:
a full contact structure comprising a single large contact (303) arranged to connect the first source field plate (201), the second source field plate (202), and the implant zones.

12. The semiconductor device of any one of claims 8 to 11, further comprising a layer of bottom field dielectric arranged on a bottom side of the deep trench, wherein a thickness of the bottom field dielectric is greater than a thickness of the first field dielectric.
